(19) Europäisches Patentamt
European Patent Office
Office européen des brevets

(11) **EP 4 123 714 B1**

(12) **EUROPEAN PATENT SPECIFICATION**

(45) Date of publication and mention
of the grant of the patent:
**05.02.2025 Bulletin 2025/06**

(21) Application number: **21771919.4**

(22) Date of filing: **13.01.2021**

(51) International Patent Classification (IPC):
*G06F 30/20* (2020.01)    *H10K 59/80* (2023.01)
*H10K 59/121* (2023.01)    *H10K 59/35* (2023.01)

(52) Cooperative Patent Classification (CPC):
**H10K 59/352; H10K 59/121; H10K 59/353;
H10K 59/80515**

(86) International application number:
**PCT/CN2021/071414**

(87) International publication number:
**WO 2021/184938 (23.09.2021 Gazette 2021/38)**

(54) **PIXEL ARRANGEMENT OPTIMIZATION METHOD, LIGHT-TRANSMITTING DISPLAY PANEL, AND DISPLAY PANEL**

VERFAHREN ZUR OPTIMIERUNG DER PIXELANORDNUNG, LICHTDURCHLÄSSIGE ANZEIGETAFEL UND ANZEIGETAFEL

PROCÉDÉ D'OPTIMISATION D'AGENCEMENT DE PIXELS, ÉCRAN D'AFFICHAGE TRANSMETTANT LA LUMIÈRE, ET ÉCRAN D'AFFICHAGE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **17.03.2020 CN 202010184309**

(43) Date of publication of application:
**25.01.2023 Bulletin 2023/04**

(73) Proprietor: **Kunshan Go-Visionox Opto-Electronics Co., Ltd.**
**KunShan, Jiangsu 215300 (CN)**

(72) Inventors:
• **ZHAO, Gaina**
**Kunshan, Jiangsu 215300 (CN)**
• **LIU, Rusheng**
**Kunshan, Jiangsu 215300 (CN)**
• **XING, Rubo**
**Kunshan, Jiangsu 215300 (CN)**
• **YIN, Hanquan**
**Kunshan, Jiangsu 215300 (CN)**
• **CAI, Junfei**
**Kunshan, Jiangsu 215300 (CN)**

(74) Representative: **von Tietzen und Hennig, Nikolaus**
**Lorenz Seidler Gossel**
**Rechtsanwälte Patentanwälte**
**Partnerschaft mbB**
**Widenmayerstraße 23**
**80538 München (DE)**

(56) References cited:
CN-A- 109 448 575    CN-A- 110 017 969
CN-A- 110 323 259    CN-A- 110 767 672
CN-A- 110 767 692    CN-A- 110 767 694
CN-A- 110 782 807    CN-A- 110 782 807
CN-A- 110 783 390    CN-A- 110 808 263
CN-A- 111 046 599    US-A- 5 959 704
US-B1- 9 312 312

## Description

### TECHNICAL FIELD

This application relates to the field of display technology, and particularly to a method and apparatus for optimizing a pixel arrangement, a light-transmitting display panel, and a display panel.

### BACKGROUND

With rapid development of electronic devices, users are requiring to have higher and higher screen-to-body ratios, so that the industry has shown more and more interest in all-screen displays of electronic devices.

There is a need for electronic devices, such as mobile phones and tablets, to have front-facing cameras, earpieces, and infrared sensing components etc. integrated thereon. In the prior art, notches or holes may be provided on display screens, so that external light can enter photosensitive components under the screens through the notches or holes on the screens. However, all such display screens are not actual all-screen displays, since not all regions across the screens can be used to display, for example, regions corresponding to front-facing cameras cannot be used to display pictures.

CN 110017969A discloses a method and apparatus for determining parameters of a transparent Organic Light Emitting Diode (OLED). The method includes obtaining working wave bands, initial optical parameters and initial structural parameters of each layer of materials of the OLED; establishing a geometric optical model of the OLED; calculating equivalent phase distribution of a transmittance function of the OLED; determining relative phase changes of the transmittance function at different working wavelengths; adjusting the initial optical parameters and the initial structural parameters, so that a relative phase change value is minimized under irradiation of central wavelengths corresponding to the working wave bands; calculating light intensity distribution of a Fraunhofer diffraction field of the OLED under irradiation of a working wavelength in the working wave bands; integrating zero-stage diffraction light intensity in the light intensity distribution of the Fraunhofer diffraction field to determine total zero-stage diffraction light intensity; and taking corresponding optical parameters and structural parameters under a condition that a value of the total zero-stage diffraction light intensity is maximum as target parameters.

CN 110782807A relates to a display panel and a display device. The display panel includes dummy sub-pixels which are located between a first pixel unit and a first boundary, and a color of the dummy sub-pixels is the same as that of second sub-pixels in a second pixel unit adjacent to a second boundary, whereby colors displayed along the boundaries on the same side of the display panel are consistent, thereby eliminating the color cast of the boundaries due to the two-color contrast and improving the display effect.

### SUMMARY

The invention is set out in the appended set of claims.

### BRIEF DESCRIPTION OF THE DRAWINGS

Other features, objects and advantages of the present application will be apparent, after reading the detailed description of non-limiting embodiments which is described with reference to the accompanying drawings, where the same or similar reference signs indicate the same or similar features. The drawings are not necessarily drawn to the actual scale.

Fig. 1 shows a schematic flowchart of a method for optimizing a pixel arrangement according to an embodiment of the present application;
Fig. 2 shows a schematic structural diagram of an apparatus for optimizing a pixel arrangement according to an embodiment of the present application;
Fig. 3 shows a schematic structural diagram of a light-transmitting display panel according to an embodiment of the present application;
Fig. 4 shows a partial enlarged schematic top view of a first example of a Q region in Fig. 3;
Fig. 5 shows a partial enlarged schematic top view of a second example of the Q region in Fig. 3;
Fig. 6 shows a partial enlarged schematic top view of a third example of the Q region in Fig. 3;
Fig. 7 shows a partial enlarged schematic top view of a fourth example of the Q region in Fig. 3; and
Fig. 8 is a schematic top view of a display panel according to an embodiment of the present application.

### DETAILED DESCRIPTION

Features and exemplary embodiments of various aspects of the present application will be described in detailed below. In order to make the objects, technical solutions and advantages of the present application clearer, the present application is further described in details below with reference to the accompany drawings and specific embodiments. It should be understood that the specific embodiments described herein are only for illustration of the present application, and are not for limiting the present application. For those skilled in the art, the present application can be implemented without some of those specific details. The below description of embodiments is only for providing better understanding of the present application by showing examples of the present application.

In an electronic device, such as a mobile phone and a tablet etc., there is a need to integrate photosensitive components (e.g., front-facing cameras, infrared light sensors, and proximity light sensors) on the side where a display panels is provided. In some embodiments, a light-transmitting display area may be provided on the above-described electronic device, and the photosensitive components may be arranged on the back of the light-transmitting display area, so that all-screen display for the electronic device can be realized, while proper operations of the photosensitive components can be guaranteed.

At present, there is still a serious diffraction phenomenon in a light-transmitting display region of a display panel, which affects a photosensitive quality of an under-screen photosensitive component.

In order to solve the above problem, embodiments of the present application provide a method and apparatus for optimizing a pixel arrangement, a light-transmitting display panel, and a display panel. Embodiments of the method and apparatus for optimizing the pixel arrangement, the light-transmitting display panel, and the display panel will be illustrated in details below in conjunction with the accompanying drawings.

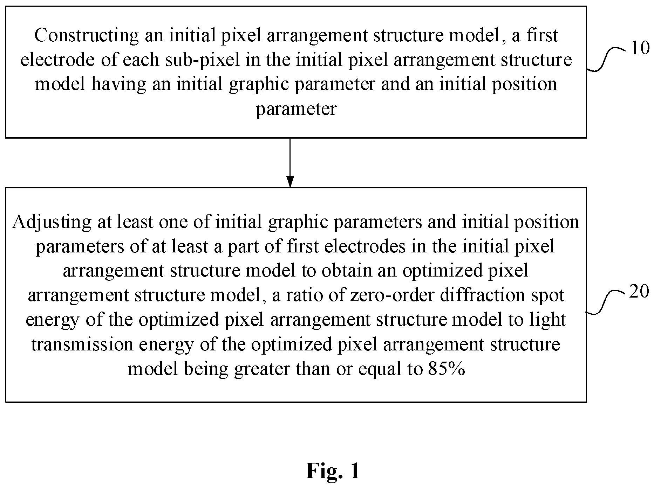

Fig. 1 shows a schematic flowchart of a method for optimizing a pixel arrangement according to an embodiment of the present application. As shown in Fig. 1, the method for optimizing the pixel arrangement includes Step 10 and Step 20.

In Step 10, an initial pixel arrangement structure model is constructed. A first electrode of each sub-pixel in the initial pixel arrangement structure model has an initial graphic parameter and an initial position parameter.

In some embodiments, any pixel arrangement structure may be selected, and the initial graphic parameter and the initial position parameter may be set for the first electrode of each sub-pixel in the pixel arrangement structure, and in turn, the initial pixel arrangement structure model may be constructed in a simulation software.

In some other embodiments, a pixel arrangement structure of a target light-transmitting display panel and a graphic parameter and a position parameter of a first electrode of each sub-pixel of the target light-transmitting display panel may be obtained; the initial pixel arrangement structure model may be constructed according to the pixel arrangement structure and the graphic parameter and the position parameter of the first electrode of each sub-pixel of the target light-transmitting display panel. The target light-transmitting display panel may be an actual light-transmitting display panel produced according to a predetermined process, the graphic parameter and position parameter of the first electrode of each sub-pixel of the target light-transmitting display panel may be imported into a simulation software, and a digital model of the target light-transmitting display panel may be constructed using the simulation software. The simulation software may be, for example, comsol, fdtd, rsoft and so forth. The target light-transmitting display panel may include first electrode and may also include an array substrate, various wiring structures, light-emitting structures, and second electrodes, etc.

The constructed initial pixel arrangement structure model may include respective film layer parameters of the target light-transmitting display panel.

As compared with producing target light-transmitting display panels under various parameters practically to obtain optimized parameters, costs can be saved and the efficiency can be improved, by constructing the initial pixel arrangement structure model of the target light-transmitting display panel and then obtaining the optimized parameters corresponding to the target light-transmitting display panel using the initial pixel arrangement structure model

In Step 20, at least one of initial graphic parameters and initial position parameters of at least a part of first electrodes in the initial pixel arrangement structure model is adjusted, to obtain an optimized pixel arrangement structure model. A ratio of zero-order diffraction spot energy of the optimized pixel arrangement structure model to light transmission energy of the optimized pixel arrangement structure model is greater than or equal to 85%.

Exemplarily, the greater the ratio of the zero-order diffraction spot energy of the optimized pixel arrangement structure model to the light transmission energy of the optimized pixel arrangement structure model, the more the mitigation of the diffraction effect of the display panel adopting the optimized pixel arrangement structure, and thus the more the improvement of the photosensitive quality of the photosensitive component positioned on the non-light emitting side of the display panel.

In some embodiments, Step 20 may specifically include:

determining whether a ratio of zero-order diffraction spot energy of the initial pixel arrangement structure model to light transmission energy of the initial pixel arrangement structure model is greater than or equal to 85% or not under conditions of different irradiation wavelengths, fields of view, and object distances; if not, adjusting continuously at least one of the initial graphic parameters and the initial position parameters of at least a part of the first electrodes in the initial pixel arrangement structure model, until the optimized pixel arrangement structure model is obtained, enabling the ratio of the zero-order diffraction spot energy of the optimized pixel arrangement structure model to the light transmission energy of the optimized pixel arrangement structure model to be greater than or equal to 85% under the conditions of different irradiation wavelengths, fields of view, and object distances.

Irradiation wavelengths may range from 400 nanometers to 800 nanometers. A field of view may be a field of photographic view of an under-screen photosensitive component, such as a field of view of a camera. A virtual object model may be constructed, and various distances between the virtual object model and the initial pixel arrangement structure model may be set. The light transmission energy is energy of light that can transmit through the pixel arrangement structure model.

Exemplarily, it is determined firstly whether the ratio of the zero-order diffraction spot energy of the initial pixel arrangement structure model to the light transmission energy of the initial pixel arrangement structure model is greater than or equal to 85% or not under the conditions of different irradiation wavelengths, fields of view, and object distances; if the initial pixel arrangement structure model meets the above condition, the initial graphic parameters and the initial position parameters of the first electrodes of the initial pixel arrangement structure model are the optimal parameters; if the initial pixel arrangement structure model does not meet the above condition, at least one of the initial graphic parameters and the initial position parameters of the first electrodes in the initial pixel arrangement structure model is adjusted continuously, and it is determined whether the adjusted pixel arrangement structure model meets the above condition or not after each adjustment, until an optimized pixel arrangement structure model is obtained.

According to the embodiments of the present application, the ratio of the zero-order diffraction spot energy to the light transmission energy for the finally obtained and optimized pixel arrangement structure model is greater than or equal to 85% under the conditions of different irradiation wavelengths, fields of view, and object distances, so as to obtain the graphic parameters and the position parameters of the first electrodes that can mitigate the diffraction phenomenon under various conditions.

In some embodiments, after Step 20, the method may further include setting a graphic parameter and a position parameter for each first electrode in the target light-transmitting display panel, according to a corresponding graphic parameter and position parameter of a corresponding first electrode in the optimized pixel arrangement structure model.

After obtaining the optimized graphic parameters and position parameters of the first electrodes, an actual target light-transmitting display panel may be produced according to the optimized graphic parameters and position parameters of the first electrodes, so that the ratio of the zero-order diffraction spot energy to the light transmission energy of the target light-transmitting display panel is greater than or equal to 85%. A proportion of the zero-order diffraction spot energy can be increased and a proportion of non-zero-order diffraction spot energy can be decreased. Therefore, the diffraction phenomenon of the target light-transmitting display panel can be mitigated, and a photosensitive quality of a photosensitive component integrated on the non-light-emitting side of the target light-transmitting display panel can be improved.

In the above embodiments, the initial graphic parameters may be shape parameters and size parameters of the first electrodes, and the initial position parameters may be coordinate parameters of the first electrodes or relative position parameters between the first electrodes.

In addition, the inventors found that periodically arranged anodes in the display panel have a greater impact on the diffraction of the light-transmitting area. By adjusting a shape, size and arrangement of an anode corresponding to each sub-pixel, the energy of the non-zero-order diffraction spot can be decreased, and the energy of the zero-order diffraction spot can be increased, so that more energy is concentrated on a geometric image point to mitigate the diffraction effect and improve an imaging quality of an under-screen camera. Therefore, in the above embodiments, a first electrode may be an anode.

So far, according to the method for optimizing the pixel arrangement of the embodiment of the present application, a ratio of zero-order diffraction spot energy of the obtained and optimized pixel arrangement structure model to light transmission energy of the optimized pixel arrangement structure model is enabled to be greater than or equal to 85% (i.e., a proportion of the zero-order diffraction spot energy is increased and a proportion of non-zero-order diffraction spot energy is decreased), by constructing an initial pixel arrangement structure model and adjusting at least one of initial graphic parameters and initial position parameters of first electrodes of at least a part of sub-pixels in the initial pixel arrangement structure model, so as to obtain graphic parameters and position parameters of the first electrodes that can mitigate the diffraction phenomenon.

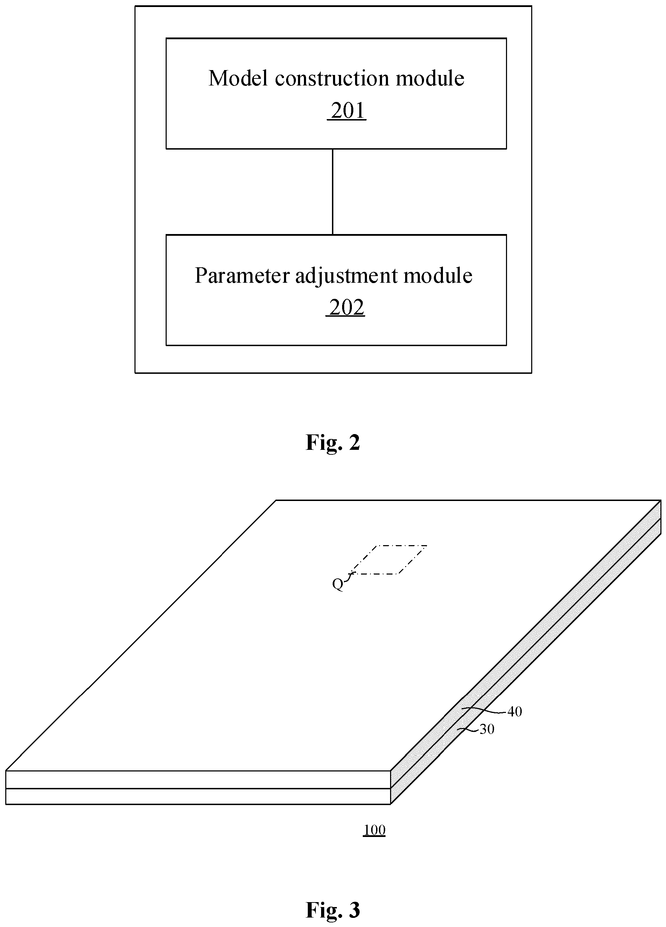

Fig. 2 shows a schematic structural diagram of an apparatus for optimizing a pixel arrangement according to an embodiment of the present application. As shown in Fig. 2, the apparatus for optimizing the pixel arrangement provided by the embodiment of the present application includes following modules.

A model construction module 201 is configured to construct an initial pixel arrangement structure model. First electrodes of respective sub-pixels in the initial pixel arrangement structure model form an initial first electrode matrix jointly. Each of the first electrodes has an initial graphic parameter and an initial position parameter.

A parameter adjustment module 202 is configured to adjust at least one of initial graphic parameters and initial position parameters of at least a part of first electrodes in the initial pixel arrangement structure model to obtain an optimized pixel arrangement structure model. A ratio of zero-order diffraction spot energy of the optimized pixel arrangement structure model to light transmission energy of the optimized pixel arrangement structure model is greater than or equal to 85%.

In some embodiments, the structure for optimizing the pixel arrangement may further include a parameter setting module, configured to set a graphic parameter and a position parameter for each first electrode in a target light-transmitting display panel, according to a corresponding graphic parameter and position parameter of a corresponding first electrode in the optimized pixel arrangement structure model.

In some embodiments, the model construction module 201 is specifically configured to:

acquire a pixel arrangement structure of a target light-transmitting display panel and a graphic parameter and a position parameter of a first electrode of each sub-pixel of the target light-transmitting display panel; and
construct the initial pixel arrangement structure model, according to the pixel arrangement structure of the target light-transmitting display panel and the graphic parameter and the position parameter of the first electrode of each sub-pixel of the target light-transmitting display panel.

In some embodiments, the parameter adjustment module 202 is specifically configured to:

determine whether a ratio of zero-order diffraction spot energy of the initial pixel arrangement structure model to light transmission energy of the initial pixel arrangement structure model is greater than or equal to 85% or not under conditions of different irradiation wavelengths, fields of view, and object distances;
if not, adjust continuously at least one of the initial graphic parameters and the initial position parameters of at least a part of the first electrodes in the initial pixel arrangement structure model, until the optimized pixel arrangement structure model is obtained, enabling the ratio of the zero-order diffraction spot energy of the optimized pixel arrangement structure model to the light transmission energy of the optimized pixel arrangement structure model to be greater than or equal to 85% under the conditions of different irradiation wavelengths, fields of view, and object distances.

According to the apparatus for optimizing the pixel arrangement of the embodiment of the present application, a ratio of zero-order diffraction spot energy of the obtained and optimized pixel arrangement structure model to light transmission energy of the optimized pixel arrangement structure model is enabled to be greater than or equal to 85% (i.e., a proportion of the zero-order diffraction spot energy is increased and a proportion of non-zero-order diffraction spot energy is decreased), by constructing an initial pixel arrangement structure model and adjusting at least one of initial graphic parameters and initial position parameters of first electrodes of at least a part of sub-pixels in the initial pixel arrangement structure model, so as to obtain graphic parameters and position parameters of the first electrodes that can mitigate the diffraction phenomenon.

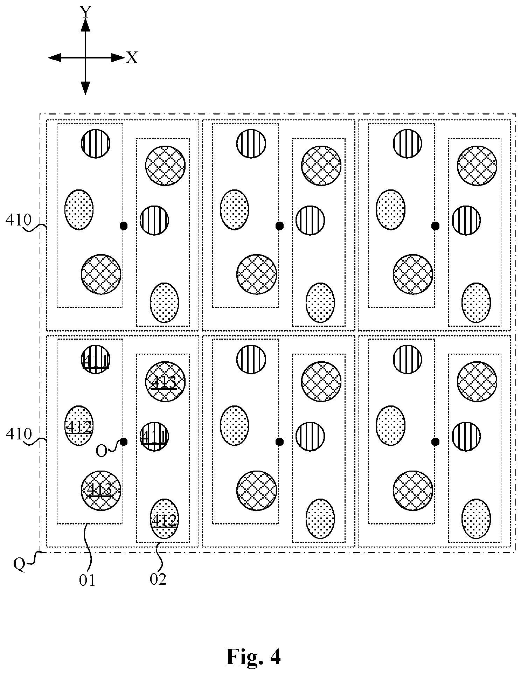

Fig. 3 shows a schematic structural diagram of a light-transmitting display panel according to an embodiment of the present application. Fig. 4 to Fig. 7 show partial enlarged views of the Q region in Fig. 3. In order to show a structure of the first electrode clearly, other structures of a light-transmitting display panel 100 are not drawn explicitly in Fig. 4 to Fig. 7.

As shown in Fig. 3 and Fig. 4 to Fig. 7, the light-transmitting display panel 100 includes an array substrate 30 and a light-emitting layer 40. The light emitting layer 40 is positioned on the array substrate 30. The light-emitting layer 40 includes a plurality of repeated units 410. A plurality of first electrodes of a plurality of sub-pixels in the repeated units 410 are arranged in a pattern. A combination of graphic parameters and position parameters of the first electrodes arranged in the pattern enables zero-order diffraction spot energy of the light-transmitting display panel 100 and light transmission energy of the light-transmitting display panel to satisfy a relationship expression (1):

$$\frac{I_0}{I_x} \geq 85\% \qquad (1)$$

In the expression (1), $I_0$ represents the zero-order diffraction spot energy of the light-transmitting display panel, and $I_x$ represents the light transmission energy of the light-transmitting display panel.

The light-transmitting display panel 100 may be an Organic Light Emitting Diode (OLED) display panel.

In some embodiments, the array substrate 30 may include pixel circuits, wiring structures, and so on. In order to improve the light transmittance of the light-transmitting display panel 100, the pixel circuits in the array substrate 30 may be arranged as exactly under respective sub-pixels as possible, and the wiring structures may be arranged deviously so as to occupy areas between the sub-pixels as less as possible. A luminescent material of a sub-pixel is vapor-deposited on an anode with low light transmittance, and a cathode of the sub-pixel is formed of a whole layer of material. Further, the inventors found that anodes periodically arranged in the display panel have a greater impact on the diffraction of the light-transmitting area. By configuring a shape, size and arrangement of an anode corresponding to each sub-pixel, the energy of the non-zero-order diffraction spot can be decreased, and the energy of the zero-order diffraction spot can be increased, so that more energy is concentrated on a geometric image point to mitigate the diffraction effect and improve an imaging quality of an under-screen camera. Therefore, a first electrode may be an anode of a sub-pixel.

Exemplarily, the graphic parameters and position parameters of the respective first electrodes in the light-transmitting display panel may be the optimized parameters obtained according to the above-mentioned method for optimizing the pixel arrangement.

According to the light-transmitting display panel of the embodiment of the present application, a combination of the graphic parameters and the position parameters of the first electrodes in the light-transmitting display panel enables a ratio of zero-order diffraction spot energy of the light-transmitting display panel to light transmission energy of the light-transmitting display panel to be greater than or equal to 85%, i.e., a proportion of the zero-order diffraction spot energy is increased and a proportion of non-zero-order diffraction spot energy is decreased. Therefore, the diffraction phenomenon of the light-transmitting display panel can be mitigated, and a photosensitive quality of a photosensitive component (for example, a camera) integrated under the screen can be improved.

In some embodiments, a sub-pixel of each color may include a first electrode, a light-emitting structure, and a second electrode that are stacked sequentially. One of the first electrode and the second electrode is an anode, and the other one is a cathode. In the embodiment, an example that the first electrode is the anode and the second electrode is the cathode is described for illustration.

The light-emitting structure may include an OLED light-emitting layer. According to a design requirement of the light-emitting structure, the OLED light-emitting layer may further include at least one of a hole injection layer, a hole transport layer, an electron injection layer, or an electron transport layer.

In some embodiments, the first electrode may include an Indium Tin Oxide (ITO) layer or an Indium Zinc Oxide layer. In some embodiments, the first electrode may be a reflective electrode, including a first light-transmitting conductive layer, a reflective layer on the first light-transmitting conductive layer, and a second light-transmitting conductive layer on the reflective layer. The first light-transmitting conductive layer and the second light-transmitting conductive layer may be the ITO layer, the Indium Zinc Oxide layer, etc., and the reflective layer may be a metal layer, for example, a layer made of silver.

In some embodiments, the second electrode may include a magnesium-silver alloy layer. In some embodiments, the second electrode may be interconnected as a common electrode.

In some embodiments, as further shown in Fig. 4, each repeated unit 410 includes a first pixel group 01 and a second pixel group 02 distributed along a first direction X, the first pixel group 01 includes a first color sub-pixel, a second color sub-pixel, and a third color sub-pixel distributed along a second direction Y, and the second pixel group 02 includes a third color sub-pixel, a first color sub-pixel, and a second color sub-pixel distributed along the second direction Y The first direction X intersects the second direction Y. An orthographic projection of a first electrode 411 of the first color sub-pixel and an orthographic projection of a first electrode 413 of the third color sub-pixel on the array substrate are circles, and an orthographic projection of a first electrode 412 of the second color sub-pixel on the array substrate is an ellipse. Further, a diameter of the first electrode 412 of the first color sub-pixel ranges from 5 micron ($\mu$m) to 25$\mu$m, a diameter of the first electrode 413 of the third color sub-pixel ranges from 8$\mu$m to 30$\mu$m, a long axis of the first electrode 412 of the second color sub-pixel ranges from 10$\mu$m to 30$\mu$m, and a short axis of the first electrode 412 of the second color sub-pixel ranges from 8$\mu$m to 20$\mu$m.

Exemplarily, before optimization, orthographic projections of first electrodes of sub-pixels of the three colors of an original light-transmitting display panel on the array substrate are all ellipses. At this time, a proportion of energy of the non-zero-order diffraction spot of the light-transmitting display panel is relatively high, and the diffraction phenomenon is obvious. The present application optimizes configuration of the first electrodes of the original light-transmitting display panel, adjusts shapes and sizes of first electrodes of sub-pixels of some color(s), and further disrupts a periodic structure of the first electrodes, so that a proportion of energy of the zero-order diffraction spot of the light-transmitting display panel can be increased, and the diffraction phenomenon of the light-transmitting display panel can be mitigated.

In some embodiments, a coordinate of a central point O of each repeated unit 410 may be set firstly. Further, a distance from the first electrode 411 of the first color sub-pixel in the first pixel group 01 to the central point O of the repeated unit 410 in the first direction X ranges from 10$\mu$m to 30$\mu$m, and a distance from the first electrode 411 of the first color sub-pixel in the first pixel group 01 to the central point O of the repeated unit 410 in the second direction Y ranges from 45$\mu$m to 65$\mu$m; a distance from a central point of the first electrode 412 of the second color sub-pixel in the first pixel group 01 to the central point O of the repeated unit 410 in the first direction X ranges from 25$\mu$m to 40$\mu$m, and a distance from a central point of the first electrode 412 of the second color sub-pixel in the first pixel group 01 to the central point O of the repeated unit 410 in the second direction Y ranges from 20$\mu$m to 40$\mu$m; a distance from a central point of the first electrode 413 of the third color sub-pixel in the first pixel group 01 to the central point O of the repeated unit 410 in the first direction X ranges from 10$\mu$m to 30$\mu$m, and a distance from the central point of the first electrode 413 of the third color sub-pixel in the first pixel group 01 to the central point O of the repeated unit 410 in the second direction Y ranges from 15$\mu$m to 30$\mu$m.

And/or, a distance from first electrode 411 of the first color sub-pixel in the second pixel group 02 to the central point O of the repeated unit 410 in the first direction X ranges from 10$\mu$m to 25$\mu$m, and a distance from first electrode 411 of the first color sub-pixel in the second pixel group 02 to the central point O of the repeated unit 410 in the second direction Y ranges from 0$\mu$m to 20$\mu$m; a distance from a central point of the first electrode 412 of the second color sub-pixel in the second pixel group 02 to the central point O of the repeated unit 410 in the first direction X ranges from 25$\mu$m to 40$\mu$m, and a distance from a central point of the first electrode 412 of the second color sub-pixel in the second pixel group 02 to the central point O of the repeated unit 410 in the second direction Y ranges from 30μm to 50μm; a distance from a central point of the first electrode 413 of the third color sub-pixel in the second pixel group 02 to the central point O of the repeated unit 410 in the first direction X ranges from 25μm to 40μm, and a distance from a central point of the first electrode 413 of the third color sub-pixel in the second pixel group 02 to the central point O of the repeated unit 410 in the second direction Y ranges from 40μm to 55μm.

This arrangement further disrupts the periodic structure of the first electrodes, so that the proportion of energy of the zero-order diffraction spot of the light-transmitting display panel can be increased and the diffraction phenomenon of the light-transmitting display panel can be mitigated.

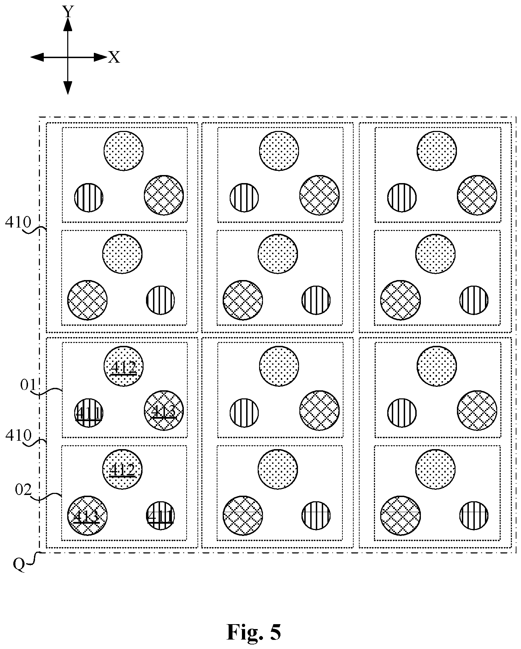

In some embodiments, as shown in Fig. 5, each repeated unit 410 includes two pixel groups distributed along the second direction Y, i.e., a first pixel group 01 and a second pixel group 02. Each pixel group includes one first color sub-pixel, one second color sub-pixel, and one third color sub-pixel. Central points of first electrodes of the three sub-pixels in each pixel group, when connected by lines, form a triangle. An arrangement structure of one of the pixel groups after being inverted by 180 degrees in the first direction X may be identical to an arrangement structure of the other one of the pixel groups in the repeated unit 410. The first direction X intersects the second direction Y. An orthographic projection of the first electrode 411, 412 or 413 of each sub-pixel on the array substrate is a circle. Further, a diameter of the first electrode 411 of the first color sub-pixel ranges from 5μm to 25μm, a diameter of the first electrode 412 of the second color sub-pixel ranges from 10μm to 30μm, and a diameter of the first electrode 413 of the third color sub-pixel ranges from 10μm to 30μm

And/or, a distance between every two of the central points of first electrodes 411, 412 and 413 of the sub-pixels of the three colors in each of the pixel groups is 15μm to 50μm, and/or the central points of first electrodes 411, 412 and 413 of the sub-pixels of the three colors in each of the pixel groups, when connected by lines, form an isosceles triangle or an equilateral triangle.

Exemplarily, before optimization, orthographic projections of first electrodes of sub-pixels of the three colors of an original light-transmitting display panel on the array substrate are all rhombuses. At this time, a proportion of energy of the non-zero-order diffraction spot of the light-transmitting display panel is relatively high, and the diffraction phenomenon is obvious. The present application optimizes configuration of the first electrodes of the original light-transmitting display panel, adjusts shapes and sizes of the first electrodes, and further disrupts a periodic structure of the first electrodes, so that a proportion of energy of the zero-order diffraction spot of the light-transmitting display panel can be increased, and the diffraction phenomenon of the light-transmitting display panel can be mitigated.

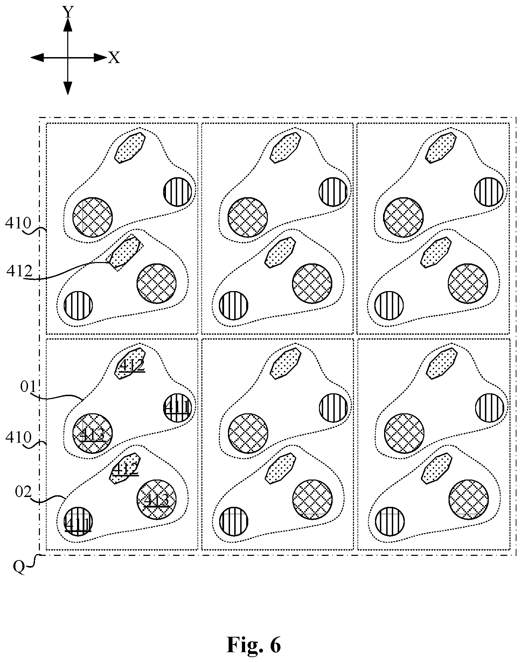

In some other embodiments, as shown in Fig. 6, each repeated unit 410 includes two pixel groups distributed along the second direction Y, i.e., a first pixel group 01 and a second pixel group 02. Each pixel group includes one first color sub-pixel, one second color sub-pixel, and one third color sub-pixel. Central points of first electrodes 411, 412 and 413 of the three sub-pixels in each of the pixel groups, when connected by lines, form a triangle. An arrangement structure of one of the pixel groups after being inverted by 180 degrees in the first direction X may be identical to an arrangement structure of the other one of the pixel groups in the repeated unit 410. The first direction intersects the second direction Y. An orthographic projection of a first electrode 411 of the first color sub-pixel and an orthographic projection of the first electrode 413 of the third color sub-pixel on the array substrate are circles, an orthographic projection of the first electrode 412 of the second color sub-pixel on the array substrate is an octagon, and virtual extension lines of four sides of the octagon constitute a rectangle.

Further, a diameter of the first electrode 411 of the first color sub-pixel ranges from 5μm to 25μm, a diameter of the first electrode 413 of the third color sub-pixel ranges from 10μm to 30μm, the long side and short side of a rectangle corresponding to the first electrode 412 of the second color sub-pixel range from 10μm to 30μm and 5μm to 25μm, respectively. And/or a distance between central points of first electrodes 411 of two first color sub-pixels is 30μm to 90μm, a distance between central points of first electrodes 412 of two second color sub-pixels is 25μm to 60μm, a distance between central points of first electrodes 413 of two third color sub-pixels is 25μm to 60μm; and/or the central points of the first electrodes 411 of the two first color sub-pixels and the central points of the first electrodes 413 of the two third color sub-pixels, when connected by lines, constitute a parallelogram.

Exemplarily, before optimization, an orthographic projection of the first electrode of the first color sub-pixel of an original light-transmitting display panel on the array substrate is a rhombus, and orthographic projections of the first electrodes of the second color sub-pixel and the third color sub-pixel on the array substrate are both octagons. At this time, a proportion of energy of the non-zero-order diffraction spot of the light-transmitting display panel is relatively high, and the diffraction phenomenon is obvious. The present application optimizes configuration of the first electrodes of the original light-transmitting display panel, adjusts shapes and sizes of first electrodes of sub-pixels of some color(s), and further disrupts a periodic structure of the first electrodes, so that a proportion of energy of the zero-order diffraction spot of the light-transmitting display panel can be increased, and the diffraction phenomenon of the light-transmitting display panel can be mitigated.

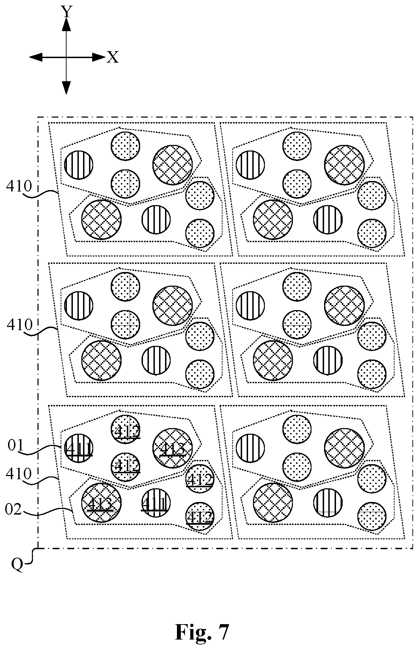

In some embodiments, as shown in Fig. 7, each repeated unit 410 includes a first pixel group 01 and a second pixel group 02 distributed along the second direction Y The first pixel group 01 includes one first color sub-pixel, two second color sub-pixels, and one third color sub-pixel distributed along the first direction X. The second pixel group 02 includes one third color sub-pixel, one first color sub-pixel, and two second color sub-pixels distributed along the first direction X. The two second color sub-pixels in each of the first pixel group 01 and the second pixel group 02 are distributed along the second direction Y The first direction X intersects the second direction Y. An orthographic projection of the first electrode 411, 412 or 413 of each sub-pixel on the array substrate is a circle

Further, a diameter of the first electrode 411 of the first color sub-pixel ranges from $5\mu m$ to $30\mu m$, a diameter of the first electrode 412 of each second color sub-pixel ranges from $5\mu m$ to $30\mu m$, and a diameter of the first electrode 413 of the third color sub-pixel ranges from $10\mu m$ to $40\mu m$. And/or, a distance between central points of the first electrodes 411 of two first color sub-pixels is $50\mu m$ to $250\mu m$, a distance between central points of the first electrodes 412 of the two second color sub-pixels in each pixel group is $10\mu m$ to $30\mu m$, a distance between central points of the first electrodes 413 of two third color sub-pixels is $10\mu m$ to $60\mu m$. And/or, the repeated unit 410 as a whole constitutes a parallelogram.

Exemplarily, before optimization, orthographic projections of first electrodes of a first color sub-pixel and a third color sub-pixel of an original light-transmitting display panel on the array substrate are both hexagons, and orthographic projections of the first electrodes of the second color sub-pixels are both pentagons. At this time, a proportion of energy of the non-zero-order diffraction spot of the light-transmitting display panel is relatively high, and the diffraction phenomenon is obvious. The present application optimizes configuration of the first electrodes of the original light-transmitting display panel, adjusts shapes and sizes of first electrodes of respective sub-pixels, and further disrupts a periodic structure of the first electrodes, so that a proportion of energy of the zero-order diffraction spot of the light-transmitting display panel can be increased, and the diffraction phenomenon of the light-transmitting display panel can be mitigated.

Further, as shown in Fig. 7, a distribution density of the repeated units 410 can be set greater to mitigate the diffraction phenomenon of the light-transmitting display panel.

In the above examples, the first color sub-pixel may be a red sub-pixel, the second color sub-pixel may be a green sub-pixel, and the third color sub-pixel may be a blue sub-pixel.

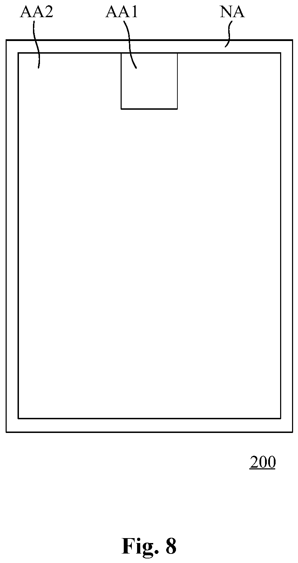

Fig. 8 is a schematic top view of a display panel according to an embodiment of the present application. As shown in Fig. 8, the display panel 200 includes a first display area AA1, a second display area AA2, and a non-display area NA surrounding the first display area AA1 and the second display area AA2. A light transmittance of the first display area AA1 is greater than that of the second display area AA2.

Here, it is preferable that the light transmittance of the first display area AA1 is greater than or equal to 15%. In order to ensure that the light transmittance of the first display area AA1 is greater than 15%, even greater than 40%, or even more, light transmittance of at least some of functional film layers of the display panel 200 of the embodiment of the present application is greater than 80% or even greater than 85%.

The display panel 200 may include a first surface S1 and a second surface S2 that are opposite to each other. The first surface S1 is a display surface. A photosensitive component may be positioned on the second surface side of the display panel 200. The photosensitive component may correspond to the position of the first display area AA1.

The photosensitive component may be image acquisition equipment that may be used to acquire external image information. In this embodiment, the photosensitive component is Complementary Metal Oxide Semiconductor (CMOS) image acquisition equipment, and in some other embodiments, the photosensitive component may be another type of image acquisition equipment, such as Charge-coupled Device (CCD) image acquisition equipment. It may be understood that the photosensitive component may not be limited to the image acquisition equipment, and for example, in some embodiments, the photosensitive component may be a light sensor such as an infrared sensor, a proximity sensor, an infrared lens, a flood light sensor, an ambient light sensor, and a dot matrix projector etc. In addition, other elements such as a receiver or a speaker, may also be integrated on the second surface of the display panel 200.

According to the display panel of the embodiment of the present application, the light transmittance of the first display area AA1 is greater than the light transmittance of the second display area AA2, so that the photosensitive component may be integrated on the back of the first display area AA1 of the display panel 200 to achieve under-screen integration of the photosensitive component (such as, image acquisition equipment), while the first display area AA1 can display pictures. Thus, the display area of the display panel 200 can be increased and a full-screen design of a display apparatus can be realized.

A combination of graphic parameters and position parameters of first electrodes in the first display area AA1 enables a ratio of zero-order diffraction spot energy of the display panel to light transmission energy of the display panel to be greater than or equal to 85%, i.e., a proportion of the zero-order diffraction spot energy can be increased and a proportion of non-zero-order diffraction spot energy can be decreased. Therefore, the diffraction phenomenon of the light-transmitting display area can be mitigated, and a photosensitive quality of a photosensitive component (for example, a camera) integrated under the screen can be improved.

Exemplarily, the display panel 200 may further include an encapsulation layer and a polarizer and a cover plate positioned above the encapsulation layer. Alternatively, the cover plate may be directly arranged at least above the encapsulation layer of the first display area AA1 without a need for the polarizer, in order to avoid the polarizer's affecting light collection amount of corresponding photosensitive elements arranged under the first display area AA1. Of course, the polarizer may also be arranged above the encapsulation layer of the first display area AA1.

The above-mentioned embodiments of the present application do not describe all details exhaustively, nor do they limit the scope of the application. Obviously, according to the above description, many modifications and changes can be made by those skilled in the art. This specification describes these embodiments in details, in order to better explain principles and practical applications of this application, so that those skilled in the art can make good use of this application and make modifications on the basis of this application. This application is only limited by the appended claims.

## Claims

1. A light-transmitting display panel (100), comprising

an array substrate (30); and
a light-emitting layer (40) positioned on the array substrate (30), the light-emitting layer (40) comprising a plurality of repeated units (410), a plurality of first electrodes (411, 412, or 413) of a plurality of sub-pixels in the repeated units (410) being arranged in a pattern, and a combination of graphic parameters and position parameters of the first electrodes (411, 412, or 413) arranged in the pattern enabling a ratio of zero-order diffraction spot energy of the light-transmitting display panel (100) to light transmission energy of the light-transmitting display panel (100) to be greater than or equal to 85%,
**characterized in that**
each of the repeated units (410) comprises a first pixel group (01) and a second pixel group (02) distributed along a first direction, the first pixel group (01) comprises a first color sub-pixel, a second color sub-pixel, and a third color sub-pixel distributed along a second direction, the second pixel group (02) comprises a third color sub-pixel, a first color sub-pixel, and a second color sub-pixel distributed along the second direction, and the first direction intersects the second direction; and
wherein an orthographic projection of a first electrode (411) of the first color sub-pixel and an orthographic projection of a first electrode (413) of the third color sub-pixel on the array substrate (30) are circles, and an orthographic projection of a first electrode (412) of the second color sub-pixel on the array substrate (30) is an ellipse and wherein a diameter of the first electrode (411) of the first color sub-pixel ranges from 5μm to 25μm, a diameter of the first electrode (413) of the third color sub-pixel ranges from 8μm to 30μm, a long axis of the first electrode (412) of the second color sub-pixel ranges from 10μm to 30μm, and a short axis of the first electrode (412) of the second color sub-pixel ranges from 8μm to 20μm.

2. The light-transmitting display panel (100) of claim 1, wherein a distance from a central point of the first electrode (411) of the first color sub-pixel in the first pixel group (01) to a central point of the repeated unit (410) in the first direction ranges from 10μm to 30μm, a distance from the central point of the first electrode (411) of the first color sub-pixel in the first pixel group (01) to the central point of the repeated unit (410) in the second direction ranges from 45μm to 65μm, a distance from a central point of the first electrode (412) of the second color sub-pixel in the first pixel group (01) to the central point of the repeated unit (410) in the first direction ranges from 25μm to 40μm, a distance from the central point of the first electrode (412) of the second color sub-pixel in the first pixel group (01) to the central point of the repeated unit (410) in the second direction ranges from 20μm to 40μm, a distance from a central point of the first electrode (413) of the third color sub-pixel in the first pixel group (01) to the central point of the repeated unit (410) in the first direction ranges from 10μm to 30μm, and a distance from the central point of the first electrode (413) of the third color sub-pixel in the first pixel group (01) to the central point of the repeated unit (410) in the second direction ranges from 15μm to 30μm; and/or
wherein a distance from a central point of the first electrode (411) of the first color sub-pixel in the second pixel group (02) to a central point of the repeated unit (410) in the first direction ranges from 10μm to 25μm, a distance from the central point of the first electrode (411) of the first color sub-pixel in the second pixel group (02) to the central point of the repeated unit (410) in the second direction ranges from 0μm to 20μm, a distance from a central point of the first electrode (412) of the second color sub-pixel in the second pixel group (02) to the central point of the repeated unit (410) in the first direction ranges from 25μm to 40μm, a distance from the central point of the first electrode (412) of the second color sub-pixel in the second pixel group (02) to the central point of the repeated unit (410) in the second direction ranges from 30μm to 50μm, a distance from a central point of the first electrode (413) of the third color sub-pixel in the second pixel group (02) to the central point of the repeated unit (410) in the first

direction ranges from $25\mu m$ to $40\mu m$, and a distance from the central point of the first electrode (413) of the third color sub-pixel in the second pixel group (02) to the central point of the repeated unit (410) in the second direction ranges from $40\mu m$ to $55\mu m$.

3. A light-transmitting display panel (100), comprising

an array substrate (30); and
a light-emitting layer (40) positioned on the array substrate (30), the light-emitting layer (40) comprising a plurality of repeated units (410), a plurality of first electrodes (411, 412, or 413) of a plurality of sub-pixels in the repeated units (410) being arranged in a pattern, and a combination of graphic parameters and position parameters of the first electrodes (411, 412, or 413) arranged in the pattern enabling a ratio of zero-order diffraction spot energy of the light-transmitting display panel (100) to light transmission energy of the light-transmitting display panel (100) to be greater than or equal to 85%, **characterized in that**
each of the repeated units (410) comprises two pixel groups (01, 02) distributed along a second direction, each of the pixel groups (01, 02) comprises one first color sub-pixel, one second color sub-pixel, and one third color sub-pixel, central points of first electrodes (411, 412, or 413) of the three sub-pixels in each of the pixel groups (01, 02), when connected by lines, form a triangle, an arrangement structure of one of the pixel groups (01, 02) after being inverted by 180 degrees in a first direction is identical to an arrangement structure of the other one of the pixel groups (01, 02) in the repeated unit (410), and the first direction intersects the second direction;
wherein an orthographic projection of a first electrode (411, 412, or 413) of each sub-pixel on the array substrate (30) is a circle; and wherein a diameter of a first electrode (411) of the first color sub-pixel ranges from $5\mu m$ to $25\mu m$, a diameter of a first electrode (412) of the second color sub-pixel ranges from $10\mu m$ to $30\mu m$, and a diameter of a first electrode (413) of the third color sub-pixel ranges from $10\mu m$ to $30\mu m$; and/or
wherein a distance between every two of central points of first electrodes (411, 412, or 413) of the first color sub-pixel, second color sub-pixel, and third color sub-pixel in each of the pixel groups (01, 02) is $15\mu m$ to $50\mu m$, and the central points of first electrodes (411, 412, or 413) of the first color sub-pixel, second color sub-pixel, and third color sub-pixel in each of the pixel groups (01, 02), when connected by lines, form an isosceles triangle or an equilateral triangle.

4. A light-transmitting display panel (100), comprising

an array substrate (30); and
a light-emitting layer (40) positioned on the array substrate (30), the light-emitting layer (40) comprising a plurality of repeated units (410), a plurality of first electrodes (411, 412, or 413) of a plurality of sub-pixels in the repeated units (410) being arranged in a pattern, and a combination of graphic parameters and position parameters of the first electrodes (411, 412, or 413) arranged in the pattern enabling a ratio of zero-order diffraction spot energy of the light-transmitting display panel (100) to light transmission energy of the light-transmitting display panel (100) to be greater than or equal to 85%, **characterized in that**
each of the repeated units (410) comprises two pixel groups (01, 02) distributed along a second direction, each of the pixel groups (01, 02) comprises one first color sub-pixel, one second color sub-pixel, and one third color sub-pixel, central points of first electrodes (411, 412, or 413) of the three sub-pixels in each of the pixel groups (01, 02), when connected by lines, form a triangle, an arrangement structure of one of the pixel groups (01, 02) after being inverted by 180 degrees in a first direction is identical to an arrangement structure of the other one of the pixel groups (01, 02) in the repeated unit (410), and the first direction intersects the second direction;
wherein an orthographic projection of a first electrode (411) of the first color sub-pixel and an orthographic projection of a first electrode (413) of the third color sub-pixel on the array substrate (30) are circles, an orthographic projection of a first electrode (412) of the second color sub-pixel on the array substrate (30) is an octagon, and virtual extension lines of four sides of the octagon constitute a rectangle; and
wherein a diameter of the first electrode (411) of the first color sub-pixel ranges from $5\mu m$ to $25\mu m$, a diameter of the first electrode (413) of the third color sub-pixel ranges from $10\mu m$ to $30\mu m$, a long side and a short side of a rectangle corresponding to the first electrode (412) of the second color sub-pixel range from $10\mu m$ to $30\mu m$ and $5\mu m$ to $25\mu m$, respectively; and/or
wherein a distance between central points of first electrodes (411) of two first color sub-pixels is $30\mu m$ to $90\mu m$, a distance between central points of first electrodes (412) of two second color sub-pixels is $25\mu m$ to $60\mu m$, a distance between central points of first electrodes (413) of two third color sub-pixels is $25\mu m$ to $60\mu m$ ; and the central points of the first electrodes (411) of the two first color sub-pixels and the central points of the first electrodes (413) of the two third color sub-pixels, when connected by lines, constitute a parallelogram.

5. A light-transmitting display panel (100), comprising

an array substrate (30); and
a light-emitting layer (40) positioned on the array substrate (30), the light-emitting layer (40) comprising a plurality of repeated units (410), a plurality of first electrodes (411, 412, or 413) of a plurality of sub-pixels in the repeated units (410) being arranged in a pattern, and a combination of graphic parameters and position parameters of the first electrodes (411, 412, or 413) arranged in the pattern enabling a ratio of zero-order diffraction spot energy of the light-transmitting display panel (100) to light transmission energy of the light-transmitting display panel (100) to be greater than or equal to 85%, **characterized in that**
each of the repeated units (410) comprises a first pixel group (01) and a second pixel group (02) distributed along a second direction, the first pixel group (01) comprises one first color sub-pixel, two second color sub-pixels, and one third color sub-pixel distributed along a first direction, the second pixel group (02) comprises one third color sub-pixel, one first color sub-pixel, and two second color sub-pixels distributed along the first direction, the two second color sub-pixels in each of the first pixel group (01) and the second pixel group (02) are distributed along the second direction, and the first direction intersects the second direction;
wherein an orthographic projection of a first electrode (411, 412, or 413) of each sub-pixel on the array substrate (30) is a circle; and wherein a diameter of a first electrode (411) of the first color sub-pixel ranges from 5μm to 30μm, a diameter of a first electrode (412) of each second color sub-pixel ranges from 5μm to 30μm, and a diameter of a first electrode (413) of the third color sub-pixel ranges from 10μm to 40μm; and/or
wherein a distance between central points of first electrodes (411) of two first color sub-pixels is 50μm to 250μm, a distance between central points of first electrodes (412) of the two second color sub-pixels in each pixel group (01 or 02) is 10μm to 30μm, a distance between central points of first electrodes (413) of two third color sub-pixels is 10μm to 60μm; and the repeated unit (410) as a whole constitutes a parallelogram.

6. A display panel (200) comprising a first display area (AA1) and a second display area (AA2) adjacent to each other, light transmittance of the first display area (AA1) being greater than light transmittance of the second display area (AA2), wherein the first display area (AA1) of the display panel (200) is configured to be the light-transmitting display panel (100) of any one of claims 1 to 5.

7. A method for optimizing a pixel arrangement, **characterized by** comprising:

constructing (10) an initial pixel arrangement structure model, a first electrode (411, 412, or 413) of each sub-pixel in the initial pixel arrangement structure model having an initial graphic parameter and an initial position parameter; and
adjusting (20) at least one of initial graphic parameters and initial position parameters of at least a part of first electrodes (411, 412, or 413) in the initial pixel arrangement structure model to obtain an optimized pixel arrangement structure model of the light-transmitting display panel (100) of any one of claims 1 to 6, a ratio of zero-order diffraction spot energy of the optimized pixel arrangement structure model to light transmission energy of the optimized pixel arrangement structure model being greater than or equal to 85%.

8. The method of claim 7, wherein after obtaining (10) the optimized pixel arrangement structure model, the method further comprises:
setting a graphic parameter and a position parameter for each first electrode (411, 412, or 413) in a target light-transmitting display panel, according to a corresponding graphic parameter and position parameter of a corresponding first electrode (411, 412, or 413) in the optimized pixel arrangement structure model.

9. The method of claim 7, wherein constructing (10) the initial pixel arrangement structure model comprises:

acquiring a pixel arrangement structure of a target light-transmitting display panel and an initial graphic parameter and an initial position parameter of a first electrode (411, 412, or 413) of each sub-pixel of the target light-transmitting display panel; and
constructing the initial pixel arrangement structure model, according to the pixel arrangement structure of the target light-transmitting display panel and the initial graphic parameter and the initial position parameter of the first electrode (411, 412, or 413) of each sub-pixel of the target light-transmitting display panel.

10. The method of claim 7, wherein adjusting (20) at least one of initial graphic parameters and initial position parameters of at least a part of first electrodes (411, 412, or 413) in the initial pixel arrangement structure model to obtain the optimized pixel arrangement structure model, a ratio of zero-order diffraction spot energy of the optimized pixel arrangement structure model to light transmission energy of the optimized pixel arrangement structure model is greater than or equal to 85% comprises:

> determining whether a ratio of zero-order diffraction spot energy of the initial pixel arrangement structure model to light transmission energy of the initial pixel arrangement structure model is greater than or equal to 85% or not under conditions of different irradiation wavelengths, fields of view, and object distances;
> under a condition that the ratio is not greater than or equal to 85%, adjusting continuously at least one of the initial graphic parameters and the initial position parameters of at least a part of the first electrodes (411, 412, or 413) in the initial pixel arrangement structure model, until the optimized pixel arrangement structure model is obtained, enabling the ratio of the zero-order diffraction spot energy of the optimized pixel arrangement structure model to the light transmission energy of the optimized pixel arrangement structure model to be greater than or equal to 85% under the conditions of different irradiation wavelengths, fields of view, and object distances.

**Patentansprüche**

1.  Lichtdurchlässiges Anzeigefeld (100), umfassend:

    > ein Array-Substrat (30); und
    > eine lichtemittierende Schicht (40), die auf dem Array-Substrat (30) positioniert ist, wobei die lichtemittierende Schicht (40) eine Vielzahl von wiederholten Einheiten (410) umfasst, wobei eine Vielzahl von ersten Elektroden (411, 412 oder 413) einer Vielzahl von Subpixeln in den wiederholten Einheiten (410) in einem Muster angeordnet sind, und eine Kombination von Grafikparametern und Positionsparametern der ersten Elektroden (411, 412 oder 413), die in dem Muster angeordnet sind, ermöglichen, dass ein Verhältnis der Beugungspunktenergie nullter Ordnung des lichtdurchlässigen Anzeigefelds (100) zu Lichtübertragungsenergie des lichtdurchlässigen Anzeigefelds (100) größer als oder gleich 85 % ist,
    > **dadurch gekennzeichnet, dass**
    > jede der wiederholten Einheiten (410) eine erste Pixelgruppe (01) und eine zweite Pixelgruppe (02) umfasst, die entlang einer ersten Richtung verteilt sind, wobei die erste Pixelgruppe (01) ein erstes Farbsubpixel, ein zweites Farbsubpixel und ein drittes Farbsubpixel umfasst, die entlang einer zweiten Richtung verteilt sind, wobei die zweite Pixelgruppe (02) ein drittes Farbsubpixel, ein erstes Farbsubpixel und ein zweites Farbsubpixel umfasst, die entlang der zweiten Richtung verteilt sind, und die erste Richtung die zweite Richtung schneidet; und
wobei eine orthografische Projektion einer ersten Elektrode (411) des ersten Farbsubpixels und eine orthografische Projektion einer ersten Elektrode (413) des dritten Farbsubpixels auf dem Array-Substrat (30) Kreise sind, und eine orthografische Projektion einer ersten Elektrode (412) des zweiten Farbsubpixels auf dem Array-Substrat (30) eine Ellipse ist, und wobei ein Durchmesser der ersten Elektrode (411) des ersten Farbsubpixels 5 $\mu$m bis 25 $\mu$m beträgt, ein Durchmesser der ersten Elektrode (413) des dritten Farbsubpixels 8 $\mu$m bis 30 $\mu$m beträgt, eine lange Achse der ersten Elektrode (412) des zweiten Farbsubpixels 10 $\mu$m bis 30 $\mu$m beträgt und eine kurze Achse der ersten Elektrode (412) des zweiten Farbsubpixels 8 $\mu$m bis 20 $\mu$m beträgt.

2.  Lichtdurchlässiges Anzeigefeld (100) nach Anspruch 1, wobei eine Distanz von einem zentralen Punkt der ersten Elektrode (411) des ersten Farbsubpixels in der ersten Pixelgruppe (01) zu einem zentralen Punkt der wiederholten Einheit (410) in der ersten Richtung 10 $\mu$m bis 30 $\mu$m beträgt, eine Distanz von dem zentralen Punkt der ersten Elektrode (411) des ersten Farbsubpixels in der ersten Pixelgruppe (01) zu dem zentralen Punkt der wiederholten Einheit (410) in der zweiten Richtung 45 $\mu$m bis 65 $\mu$m beträgt, eine Distanz von einem zentralen Punkt der ersten Elektrode (412) des zweiten Farbsubpixels in der ersten Pixelgruppe (01) zu dem zentralen Punkt der wiederholten Einheit (410) in der ersten Richtung 25 $\mu$m bis 40 $\mu$m beträgt, eine Distanz von dem zentralen Punkt der ersten Elektrode (412) des zweiten Farbsubpixels in der ersten Pixelgruppe (01) zu dem zentralen Punkt der wiederholten Einheit (410) in der zweiten Richtung 20 $\mu$m bis 40 $\mu$m beträgt, eine Distanz von einem zentralen Punkt der ersten Elektrode (413) des dritten Farbsubpixels in der ersten Pixelgruppe (01) zu dem zentralen Punkt der wiederholten Einheit (410) in der ersten Richtung 10 $\mu$m bis 30 $\mu$m beträgt und eine Distanz von dem zentralen Punkt der ersten Elektrode (413) des dritten Farbsubpixels in der ersten Pixelgruppe (01) zu dem zentralen Punkt der wiederholten Einheit (410) in der zweiten Richtung 15 $\mu$m bis 30 $\mu$m beträgt; und/oder
wobei eine Distanz von einem zentralen Punkt der ersten Elektrode (411) des ersten Farbsubpixels in der zweiten Pixelgruppe (02) zu einem zentralen Punkt der wiederholten Einheit (410) in der ersten Richtung 10 μm bis 25 μm beträgt, eine Distanz von dem zentralen Punkt der ersten Elektrode (411) des ersten Farbsubpixels in der zweiten Pixelgruppe (02) zu dem zentralen Punkt der wiederholten Einheit (410) in der zweiten Richtung 0 μm bis 20 μm beträgt, eine Distanz von einem zentralen Punkt der ersten Elektrode (412) des zweiten Farbsubpixels in der zweiten Pixelgruppe (02) zu dem zentralen Punkt der wiederholten Einheit (410) in der ersten Richtung 25 μm bis 40 μm beträgt, eine Distanz von dem zentralen Punkt der ersten Elektrode (412) des zweiten Farbsubpixels in der zweiten Pixelgruppe (02) zu dem zentralen Punkt der wiederholten Einheit (410) in der zweiten Richtung 30 μm bis 50 μm beträgt, eine Distanz von einem zentralen Punkt der ersten Elektrode (413) des dritten Farbsubpixels in der zweiten Pixelgruppe (02) zu dem zentralen Punkt der wiederholten Einheit (410) in der ersten Richtung 25 μm bis 40 μm beträgt, und eine Distanz von dem zentralen Punkt der ersten Elektrode (413) des dritten Farbsubpixels in der zweiten Pixelgruppe (02) zu dem zentralen Punkt der wiederholten Einheit (410) in der zweiten Richtung 40 μm bis 55 μm beträgt.

3. Lichtdurchlässiges Anzeigefeld (100), umfassend:

ein Array-Substrat (30); und eine lichtemittierende Schicht (40), die auf dem Array-Substrat (30) positioniert ist, wobei die lichtemittierende Schicht (40) eine Vielzahl von wiederholten Einheiten (410) umfasst, wobei eine Vielzahl von ersten Elektroden (411, 412 oder 413) einer Vielzahl von Subpixeln in den wiederholten Einheiten (410) in einem Muster angeordnet sind, und eine Kombination von Grafikparametern und Positionsparametern der ersten Elektroden (411, 412 oder 413), die in dem Muster angeordnet sind, ermöglicht, dass ein Verhältnis der Beugungspunktenergie nullter Ordnung des lichtdurchlässigen Anzeigefelds (100) zu der Lichtübertragungsenergie des lichtdurchlässigen Anzeigefelds (100) größer als oder gleich 85 % ist, **dadurch gekennzeichnet, dass** jede der wiederholten Einheiten (410) zwei Pixelgruppen (01, 02) umfasst, die entlang einer zweiten Richtung verteilt sind, wobei jede der Pixelgruppen (01, 02) ein erstes Farbsubpixel, ein zweites Farbsubpixel und ein drittes Farbsubpixel umfasst, wobei zentrale Punkte der ersten Elektroden (411, 412 oder 413) der drei Subpixel in jeder der Pixelgruppen (01, 02), wenn sie durch Linien verbunden sind, ein Dreieck bilden, wobei eine Anordnungsstruktur einer der Pixelgruppen (01, 02), nachdem sie um 180 Grad in einer ersten Richtung umgedreht wird, identisch zu einer Anordnungsstruktur der anderen der Pixelgruppen (01, 02) in der wiederholten Einheit (410) ist und die erste Richtung die zweite Richtung schneidet; wobei eine orthografische Projektion einer ersten Elektrode (411, 412 oder 413) jedes Subpixels auf dem Array-Substrat (30) ein Kreis ist; und wobei ein Durchmesser einer ersten Elektrode (411) des ersten Farbsubpixels 5 μm bis 25 μm beträgt, ein Durchmesser einer ersten Elektrode (412) des zweiten Farbsubpixels 10 μm bis 30 μm beträgt und ein Durchmesser einer ersten Elektrode (413) des dritten Farbsubpixels 10 μm bis 30 μm beträgt; und/oder wobei eine Distanz zwischen jeweils zwei der zentralen Punkte der ersten Elektroden (411, 412 oder 413) des ersten Farbsubpixels, des zweiten Farbsubpixels und des dritten Farbsubpixels in jeder der Pixelgruppen (01, 02) 15 μm bis 50 μm beträgt, und die zentralen Punkte der ersten Elektroden (411, 412 oder 413) des ersten Farbsubpixels, des zweiten Farbsubpixels und des dritten Farbsubpixels in jeder der Pixelgruppen (01, 02), wenn sie durch Linien verbunden sind, ein gleichschenkliges Dreieck oder ein gleichseitiges Dreieck bilden.

4. Lichtdurchlässiges Anzeigefeld (100), umfassend:

ein Array-Substrat (30); und eine lichtemittierende Schicht (40), die auf dem Array-Substrat (30) positioniert ist, wobei die lichtemittierende Schicht (40) eine Vielzahl von wiederholten Einheiten (410) umfasst, wobei eine Vielzahl von ersten Elektroden (411, 412 oder 413) einer Vielzahl von Subpixeln in den wiederholten Einheiten (410) in einem Muster angeordnet sind, und eine Kombination von Grafikparametern und Positionsparametern der ersten Elektroden (411, 412 oder 413), die in dem Muster angeordnet sind, ermöglicht, dass ein Verhältnis der Beugungspunktenergie nullter Ordnung des lichtdurchlässigen Anzeigefelds (100) zu der Lichtübertragungsenergie des lichtdurchlässigen Anzeigefelds (100) größer als oder gleich 85 % ist, **dadurch gekennzeichnet, dass** jede der wiederholten Einheiten (410) zwei Pixelgruppen (01, 02) umfasst, die entlang einer zweiten Richtung verteilt sind, wobei jede der Pixelgruppen (01, 02) ein erstes Farbsubpixel, ein zweites Farbsubpixel und ein drittes Farbsubpixel umfasst, wobei zentrale Punkte der ersten Elektroden (411, 412 oder 413) der drei Subpixel in jeder der Pixelgruppen (01, 02), wenn sie durch Linien verbunden sind, ein Dreieck bilden, wobei eine Anordnungsstruktur einer der Pixelgruppen (01, 02), nachdem sie um 180 Grad in einer ersten Richtung umgedreht wird, identisch zu einer Anordnungsstruktur der anderen der Pixelgruppen (01, 02) in der wiederholten Einheit (410) ist und die erste Richtung die zweite Richtung schneidet;
wobei eine orthografische Projektion einer ersten Elektrode (411) des ersten Farbsubpixels und eine orthografische Projektion einer ersten Elektrode (413) des dritten Farbsubpixels auf dem Array-Substrat (30) Kreise sind, wobei eine orthografische Projektion einer ersten Elektrode (412) des zweiten Farbsubpixels auf dem Array-Substrat (30) ein Achteck ist, und virtuelle Verlängerungslinien von vier Seiten des Achtecks ein Rechteck bilden; und wobei ein Durchmesser der ersten Elektrode (411) des ersten Farbsubpixels 5 $\mu$m bis 25 $\mu$m beträgt, ein Durchmesser der ersten Elektrode (413) des dritten Farbsubpixels 10 $\mu$m bis 30 $\mu$m beträgt, eine lange Seite und eine kurze Seite eines Rechtecks entsprechend der ersten Elektrode (412) des zweiten Farbsubpixels jeweils 10 $\mu$m bis 30 $\mu$m und 5 $\mu$m bis 25 $\mu$m betragen; und/oder
wobei eine Distanz zwischen zentralen Punkten der ersten Elektroden (411) von zwei ersten Farbsubpixeln 30 $\mu$m bis 90 $\mu$m beträgt, eine Distanz zwischen zentralen Punkten der ersten Elektroden (412) von zwei zweiten Farbsubpixeln 25 $\mu$m bis 60 $\mu$m beträgt, eine Distanz zwischen zentralen Punkten der ersten Elektroden (413) von zwei dritten Farbsubpixeln 25 $\mu$m bis 60 $\mu$m beträgt; und die zentralen Punkte der ersten Elektroden (411) der beiden ersten Farbsubpixel und die zentralen Punkte der ersten Elektroden (413) der beiden dritten Farbsubpixel, wenn sie durch Linien verbunden sind, ein Parallelogramm bilden.

5. Lichtdurchlässiges Anzeigefeld (100), umfassend:

ein Array-Substrat (30); und
eine lichtemittierende Schicht (40), die auf dem Array-Substrat (30) positioniert ist, wobei die lichtemittierende Schicht (40) eine Vielzahl von wiederholten Einheiten (410) umfasst, wobei eine Vielzahl der ersten Elektroden (411, 412 oder 413) einer Vielzahl von Subpixeln in den wiederholten Einheiten (410) in einem Muster angeordnet sind, und eine Kombination von Grafikparametern und Positionsparametern der ersten Elektroden (411, 412 oder 413), die in dem Muster angeordnet sind, ermöglichen, dass ein Verhältnis der Beugungspunktenergie nullter Ordnung des lichtdurchlässigen Anzeigefelds (100) zu der Lichtübertragungsenergie des lichtdurchlässigen Anzeigefelds (100) größer als oder gleich 85 % ist,

**dadurch gekennzeichnet, dass**
jede der wiederholten Einheiten (410) eine erste Pixelgruppe (01) und eine zweite Pixelgruppe (02) umfasst, die entlang einer zweiten Richtung verteilt sind, die erste Pixelgruppe (01) ein erstes Farbsubpixel, zwei zweite Farbsubpixel und ein drittes Farbsubpixel umfasst, die entlang einer ersten Richtung angeordnet sind, die zweite Pixelgruppe (02) ein drittes Farbsubpixel, ein erstes Farbsubpixel und zwei zweite Farbsubpixel umfasst, die entlang der ersten Richtung verteilt sind, wobei die beiden zweiten Farbsubpixel in jeder der ersten Pixelgruppe (01) und der zweiten Pixelgruppe (02) entlang der zweiten Richtung verteilt sind und die erste Richtung die zweite Richtung schneidet;
wobei eine orthografische Projektion einer ersten Elektrode (411, 412 oder 413) jedes Subpixels auf dem Array-Substrat (30) ein Kreis ist; und wobei ein Durchmesser einer ersten Elektrode (411) des ersten Farbsubpixels 5 $\mu$m bis 30 $\mu$m beträgt, ein Durchmesser einer ersten Elektrode (412) jedes zweiten Farbsubpixels 5 $\mu$m bis 30 $\mu$m beträgt und ein Durchesser einer ersten Elektrode (413) des dritten Farbsubpixels 10 $\mu$m bis 40 $\mu$m beträgt; und/oder
wobei eine Distanz zwischen zentralen Punkten der ersten Elektroden (411) von zwei ersten Farbsubpixeln 50 $\mu$m bis 250 $\mu$m beträgt, eine Distanz zwischen zentralen Punkten der ersten Elektroden (412) der beiden zweiten Farbsubpixel in jeder Pixelgruppe (01 oder 02) 10 $\mu$m bis 30 $\mu$m beträgt, eine Distanz zwischen zentralen Punkten der ersten Elektroden (413) von zwei dritten Farbsubpixeln 10 $\mu$m bis 60 $\mu$m beträgt; und
die wiederholte Einheit (410) als Ganzes ein Parallelogramm bildet.

6. Anzeigefeld (200) umfassend einen ersten Anzeigebereich (AA1) und einen zweiten Anzeigebereich (AA2), die benachbart zueinander sind, wobei die Lichtdurchlässigkeit des ersten Anzeigebereichs (AA1) größer ist als die Lichtdurchlässigkeit des zweiten Anzeigebereichs (AA2), wobei der erste Anzeigebereich (AA1) des Anzeigefelds (200) so konfiguriert ist, dass er das lichtdurchlässige Anzeigefeld (100) nach einem der Ansprüche 1 bis 5 ist.

7. Verfahren zum Optimieren einer Pixelanordnung, **dadurch gekennzeichnet, dass** es Folgendes umfasst:

Konstruieren (10) eines Anfangspixelanordnungsstrukturmodells, wobei eine erste Elektrode (411, 412 oder 413) jedes Subpixels in dem Anfangspixelanordnungsstrukturmodell einen Anfangsgrafikparameter und einen Anfangspositionsparameter aufweist; und

Anpassen (20) von mindestens einem der Anfangsgrafikparameter und Anfangspositionsparameter von mindestens einem Teil der ersten Elektroden (411, 412 oder 413) in dem Anfangspixelanordnungsstrukturmodell, um ein optimiertes Pixelanordnungsstrukturmodell des lichtdurchlässigen Anzeigefelds (100) nach einem der Ansprüche 1 bis 6 zu erhalten, wobei ein Verhältnis der Beugungspunktenergie nullter Ordnung des optimierten Pixelanordnungsstrukturmodells zu der Lichtübertragungsenergie des optimierten Pixelanordnungsstrukturmodells größer als oder gleich 85 % ist.

8. Verfahren nach Anspruch 7, wobei nach dem Erhalten (10) des optimierten Pixelanordnungsstrukturmodells das Verfahren ferner Folgendes umfasst: Festlegen eines Grafikparameters und eines Positionsparameters für jede erste Elektrode (411, 412 oder 413) in einem lichtdurchlässigen Zielanzeigefeld gemäß einem entsprechenden Grafikparameter und Positionsparameter einer entsprechenden ersten Elektrode (411, 412 oder 413) in dem optimierten Pixelanordnungsstrukturmodell.

9. Verfahren nach Anspruch 7, wobei das Konstruieren (10) des Anfangspixelanordnungsstrukturmodells Folgendes umfasst:

Erfassen einer Pixelanordnungsstruktur eines lichtdurchlässigen Zielanzeigefelds und eines Anfangsgrafikparameters und eines Anfangspositionsparameters einer ersten Elektrode (411, 412 oder 413) jedes Subpixels des lichtdurchlässigen Zielanzeigefelds; und

Konstruieren des Anfangspixelanordnungsstrukturmodells gemäß der Pixelanordnungsstruktur des lichtdurchlässigen Zielanzeigefelds und des Anfangsgrafikparameters und des Anfangspositionsparameters der ersten Elektrode (411, 412 oder 413) jedes Subpixels des lichtdurchlässigen Zielanzeigefelds.

10. Verfahren nach Anspruch 7, wobei das Anpassen (20) von mindestens einem der Anfangsgrafikparameter und der Anfangspositionsparameter von mindestens einem Teil der ersten Elektroden (411, 412 oder 413) in dem Anfangspixelanordnungsstrukturmodell zum Erhalten des optimierten Pixelanordnungsstrukturmodells, wobei ein Verhältnis der Beugungspunktenergie nullter Ordnung des optimierten Pixelanordnungsstrukturmodells zu der Lichtübertragungsenergie des optimierten Pixelanordnungsstrukturmodells größer als oder gleich 85 % ist, Folgendes umfasst:

Bestimmen, ob ein Verhältnis der Beugungspunktenergie nullter Ordnung des Anfangspixelanordnungsstrukturmodells zu der Lichtübertragungsenergie des Anfangspixelanordnungsstrukturmodells größer als oder gleich 85 % ist oder nicht unter Bedingungen unterschiedlicher Strahlungswellenlängen, Sichtfeldern und Objektdistanzen;

unter einer Bedingung, dass das Verhältnis nicht größer als oder gleich 85 % ist, kontinuierliches Anpassen von mindestens einem der Anfangsgrafikparameter und der Anfangspositionsparameter von mindestens einem Teil der ersten Elektroden (411, 412 oder 413) in dem Anfangspixelanordnungsstrukturmodell, bis das optimierte Pixelanordnungsstrukturmodell erhalten wird, Ermöglichen, dass das Verhältnis der Beugungspunktenergie nullter Ordnung des optimierten Pixelanordnungsstrukturmodells größer als oder gleich 85 % ist unter den Bedingungen unterschiedlicher Strahlungswellenlängen, Sichtfelder und Objektdistanzen.

## Revendications

1. Panneau d'affichage transmettant la lumière (100), comprenant :

un substrat matriciel (30) ; et
une couche électroluminescente (40) positionnée sur le substrat matriciel (30), la couche électroluminescente (40) comprenant une pluralité d'unités répétées (410), une pluralité de premières électrodes (411, 412 ou 413) d'une pluralité de sous-pixels dans les unités répétées (410) étant disposées selon un motif, et une combinaison de paramètres graphiques et de paramètres de position des premières électrodes (411, 412 ou 413) disposées selon le motif permettant à un rapport entre l'énergie de point de diffraction d'ordre zéro du panneau d'affichage transmettant la lumière (100) et l'énergie de transmission de lumière du panneau d'affichage transmettant la lumière (100) d'être supérieur ou égal à 85 %,
**caractérisé en ce que**
chacune des unités répétées (410) comprend un premier groupe de pixels (01) et un second groupe de pixels (02) répartis le long d'une première direction, le premier groupe de pixels (01) comprend un premier sous-pixel de couleur, un deuxième sous-pixel de couleur et un troisième sous-pixel de couleur répartis le long d'une deuxième direction, le second groupe de pixels (02) comprend un troisième sous-pixel de couleur, un premier sous-pixel de couleur et un deuxième sous-pixel de couleur répartis le long de la deuxième direction, et la première direction croise la deuxième direction ; et

dans lequel une projection orthographique d'une première électrode (411) du premier sous-pixel de couleur et une projection orthographique d'une première électrode (413) du troisième sous-pixel de couleur sur le substrat matriciel (30) sont des cercles, et une projection orthographique d'une première électrode (412) du deuxième sous-pixel de couleur sur le substrat matriciel (30) est une ellipse et dans lequel un diamètre de la première électrode (411) du premier sous-pixel de couleur va de 5 μm à 25 μm, un diamètre de la première électrode (413) du troisième sous-pixel de couleur va de 8 μm à 30 μm, un axe long de la première électrode (412) du deuxième sous-pixel de couleur va de 10 μm à 30 μm, et un axe court de la première électrode (412) du deuxième sous-pixel de couleur va de 8 μm à 20 μm.

2. Panneau d'affichage transmettant la lumière (100) selon la revendication 1, dans lequel une distance d'un point central de la première électrode (411) du premier sous-pixel de couleur dans le premier groupe de pixels (01) à un point central de l'unité répétée (410) dans la première direction va de 10 μm à 30 μm, une distance du point central de la première électrode (411) du premier sous-pixel de couleur dans le premier groupe de pixels (01) au point central de l'unité répétée (410) dans la deuxième direction va de 45 μm à 65 μm, une distance d'un point central de la première électrode (412) du deuxième sous-pixel de couleur dans le premier groupe de pixels (01) au point central de l'unité répétée (410) dans la première direction va de 25 μm à 40 μm, une distance du point central de la première électrode (412) du second sous-pixel de couleur dans le premier groupe de pixels (01) au point central de l'unité répétée (410) dans la deuxième direction va de 20 μm à 40 μm, une distance d'un point central de la première électrode (413) du troisième sous-pixel de couleur dans le premier groupe de pixels (01) au point central de l'unité répétée (410) dans la première direction va de 10 μm à 30 μm, et une distance du point central de la première électrode (413) du troisième sous-pixel de couleur dans le premier groupe de pixels (01) au point central de l'unité répétée (410) dans la deuxième direction va de 15 μm à 30 μm ; et/ou

dans lequel une distance d'un point central de la première électrode (411) du premier sous-pixel de couleur dans le second groupe de pixels (02) à un point central de l'unité répétée (410) dans la première direction va de 10 μm à 25 μm, une distance du point central de la première électrode (411) du premier sous-pixel de couleur dans le second groupe de pixels (02) au point central de l'unité répétée (410) dans la deuxième direction va de 0 μm à 20 μm, une distance d'un point central de la première électrode (412) du deuxième sous-pixel de couleur dans le second groupe de pixels (02) au point central de l'unité répétée (410) dans la première direction va de 25 μm à 40 μm, une distance du point central de la première électrode (412) du deuxième sous-pixel de couleur dans le second groupe de pixels (02) au point central de l'unité répétée (410) dans la deuxième direction va de 30 μm à 50 μm, une distance d'un point central de la première électrode (413) du troisième sous-pixel de couleur dans le second groupe de pixels (02) au point central de l'unité répétée (410) dans la première direction va de 25 μm à 40 μm, et une distance du point central de la première électrode (413) du troisième sous-pixel de couleur dans le second groupe de pixels (02) au point central de l'unité répétée (410) dans la deuxième direction va de 40 μm à 55 μm.

3. Panneau d'affichage transmettant la lumière (100), comprenant un substrat matriciel (30) ; et

une couche électroluminescente (40) positionnée sur le substrat matriciel (30), la couche électroluminescente (40) comprenant une pluralité d'unités répétées (410), une pluralité de premières électrodes (411, 412 ou 413) d'une pluralité de sous-pixels dans les unités répétées (410) étant disposées selon un motif, et une combinaison de paramètres graphiques et de paramètres de position des premières électrodes (411, 412 ou 413) disposées selon le motif permettant à un rapport entre l'énergie de point de diffraction d'ordre zéro du panneau d'affichage transmettant la lumière (100) et l'énergie de transmission de lumière du panneau d'affichage transmettant la lumière (100) d'être supérieur ou égal à 85 %,
**caractérisé en ce que**
chacune des unités répétées (410) comprend deux groupes de pixels (01, 02) répartis le long d'une deuxième direction, chacun des groupes de pixels (01, 02) comprend un premier sous-pixel de couleur, un deuxième sous-pixel de couleur et un troisième sous-pixel de couleur, des points centraux de premières électrodes (411, 412 ou 413) des trois sous-pixels dans chacun des groupes de pixels (01, 02), lorsqu'ils sont connectés par des lignes, forment un triangle, une structure d'agencement d'un des groupes de pixels (01, 02) après avoir été inversée de 180 degrés dans une première direction est identique à une structure d'agencement de l'autre des groupes de pixels (01, 02) dans l'unité répétée (410), et la première direction croise la deuxième direction ;

dans lequel une projection orthographique d'une première électrode (411, 412 ou 413) de chaque sous-pixel sur le substrat matriciel (30) est un cercle ; et dans lequel un diamètre d'une première électrode (411) du premier sous-pixel de couleur va de 5 μm à 25 μm, un diamètre d'une première électrode (412) du deuxième sous-pixel de couleur va de 10 μm à 30 μm, et un diamètre d'une première électrode (413) du troisième sous-pixel de couleur va de 10 μm à 30 μm ; et/ou

dans lequel une distance entre chaque paire de points centraux de premières électrodes (411, 412 ou 413) du premier sous-pixel de couleur, du deuxième sous-pixel de couleur et du troisième sous-pixel de couleur dans chacun des groupes de pixels (01, 02) va 15 μm à 50 μm, et les points centraux de premières électrodes (411, 412 ou 413) du premier sous-pixel de couleur, du deuxième sous-pixel de couleur et du troisième sous-pixel de couleur dans chacun des groupes de pixels (01, 02), lorsqu'ils sont connectés par des lignes, forment un triangle isocèle ou un triangle équilatéral.

4. Panneau d'affichage transmettant la lumière (100) comprenant :

un substrat matriciel (30) ; et
une couche électroluminescente (40) positionnée sur le substrat matriciel (30), la couche électroluminescente (40) comprenant une pluralité d'unités répétées (410), une pluralité de premières électrodes (411, 412 ou 413) d'une pluralité de sous-pixels dans les unités répétées (410) étant disposées selon un motif, et une combinaison de paramètres graphiques et de paramètres de position des premières électrodes (411, 412 ou 413) disposées selon le motif permettant à un rapport entre l'énergie de point de diffraction d'ordre zéro du panneau d'affichage transmettant la lumière (100) et l'énergie de transmission de lumière du panneau d'affichage transmettant la lumière (100) d'être supérieur ou égal à 85 %,
**caractérisé en ce que**
chacune des unités répétées (410) comprend deux groupes de pixels (01, 02) répartis le long d'une deuxième direction, chacun des groupes de pixels (01, 02) comprend un premier sous-pixel de couleur, un deuxième sous-pixel de couleur et un troisième sous-pixel de couleur, des points centraux de premières électrodes (411, 412 ou 413) des trois sous-pixels dans chacun des groupes de pixels (01, 02), lorsqu'ils sont connectés par des lignes, forment un triangle, une structure d'agencement d'un des groupes de pixels (01, 02) après avoir été inver

sée de 180 degrés dans une première direction est identique à une structure d'agencement de l'autre des groupes de pixels (01, 02) dans l'unité répétée (410), et la première direction croise la deuxième direction ;
dans lequel la projection orthographique d'une première électrode (411) du premier sous-pixel de couleur et une projection orthographique d'une première électrode (413) du troisième sous-pixel de couleur sur le substrat matriciel (30) sont des cercles, une projection orthographique d'une première électrode (412) du deuxième sous-pixel de couleur sur le substrat matriciel (30) est un octogone, et les lignes d'extension virtuelles de quatre côtés de l'octogone constituent un rectangle ; et dans lequel un diamètre de la première électrode (411) du premier sous-pixel de couleur va de 5 μm à 25 μm, un diamètre de la première électrode (413) du troisième sous-pixel de couleur va de 10 μm à 30 μm, un côté long et un côté court d'un rectangle correspondant à la première électrode (412) du deuxième sous-pixel de couleur vont de 10 μm à 30 μm et de 5 μm à 25 μm, respectivement ; et/ou
dans lequel une distance entre des points centraux de premières électrodes (411) de deux premiers sous-pixels de couleur va de 30 μm à 90 μm, une distance entre des points centraux de premières électrodes (412) de deux deuxièmes sous-pixels de couleur va de 25 μm à 60 μm, une distance entre des points centraux de premières électrodes (413) de deux troisièmes sous-pixels de couleur va de 25 μm à 60 μm ; et
les points centraux des premières électrodes (411) des deux premiers sous-pixels de couleur et les points centraux des premières électrodes (413) des deux troisièmes sous-pixels de couleur, lorsqu'ils sont connectés par des lignes, constituent un parallélogramme.

5. Panneau d'affichage transmettant la lumière (100) comprenant :

un substrat matriciel (30) ; et
une couche électroluminescente (40) positionnée sur le substrat matriciel (30), la couche électroluminescente (40) comprenant une pluralité d'unités répétées (410), une pluralité de premières électrodes (411, 412 ou 413) d'une pluralité de sous-pixels dans les unités répétées (410) étant disposées selon un motif, et une combinaison de paramètres graphiques et de paramètres de position des premières électrodes (411, 412 ou 413) disposées selon le motif permettant à un rapport entre l'énergie de point de diffraction d'ordre zéro du panneau d'affi

chage transmettant la lumière (100) et l'énergie de transmission de lumière du panneau d'affichage transmettant la lumière (100) d'être supérieur ou égal à 85 %,

**caractérisé en ce que**

chacune des unités répétées (410) comprend un premier groupe de pixels (01) et un second groupe de pixels (02) répartis le long d'une deuxième direction, le premier groupe de pixels (01) comprend un premier sous-pixel de couleur, deux deuxièmes sous-pixels de couleur, et un troisième sous-pixel de couleur répartis le long d'une première direction, le second groupe de pixels (02) comprend un troisième sous-pixel de couleur, un premier sous-pixel de couleur, et deux deuxièmes sous-pixels de couleur répartis le long de la première direction, les deux deuxièmes sous-pixels de couleur dans chacun du premier groupe de pixels (01) et du second groupe de pixels (02) sont répartis le long de la deuxième direction, et la première direction croise la deuxième direction ;

dans lequel une projection orthographique d'une première électrode (411, 412 ou 413) de chaque sous-pixel sur le substrat matriciel (30) est un cercle ; et dans lequel un diamètre d'une première électrode (411) du premier sous-pixel de couleur va de 5 μm à 30 μm, un diamètre d'une première électrode (412) de chaque deuxième sous-pixel de couleur va de 5 μm à 30 μm, et un diamètre d'une première électrode (413) du troisième sous-pixel de couleur va de 10 μm à 40 μm ; et/ou

dans lequel une distance entre des points centraux de premières électrodes (411) de deux premiers sous-pixels de couleur va de 50 μm à 250 μm, une distance entre des points centraux de premières électrodes (412) des deux deuxièmes sous-pixels de couleur dans chaque groupe de pixels (01 ou 02) va de 10 μm à 30 μm, une distance entre des points centraux de premières électrodes (413) de deux troisièmes sous-pixels de couleur va de 10 μm à 60 μm ; et/ou

l'unité répétée (410) dans son ensemble constitue un parallélogramme.

6. Panneau d'affichage (200) comprenant une première zone d'affichage (AA1) et une deuxième zone d'affichage (AA2) adjacentes l'une à l'autre, la transmittance de lumière de la première zone d'affichage (AA1) étant supérieure à la transmittance de lumière de la deuxième zone d'affichage (AA2), dans lequel la première zone d'affichage (AA1) du panneau d'affichage (200) est configurée pour être le panneau d'affichage transmettant la lumière (100) selon l'une quelconque des revendications 1 à 5.

7. Procédé d'optimisation d'un agencement de pixels, **caractérisé en ce qu'**il comprend :

l'élaboration (10) d'un modèle de structure d'agencement de pixels initial, une première électrode (411, 412 ou 413) de chaque sous-pixel dans le modèle de structure d'agencement de pixels initial présentant un paramètre graphique initial et un paramètre de position initial ; et

l'ajustement (20) d'au moins un de paramètres graphiques initiaux et de paramètres de position initiaux d'au moins une partie de premières électrodes (411, 412 ou 413) dans le modèle de structure d'agencement de pixels initial pour obtenir un modèle de structure d'agencement de pixels optimisé du panneau d'affichage transmettant de la lumière (100) selon l'une quelconque des revendications 1 à 6, un rapport entre l'énergie de point de diffraction d'ordre zéro du modèle de structure d'agencement de pixels optimisé et l'énergie de transmission de lumière du modèle de structure d'agencement de pixels optimisé étant supérieur ou égal à 85 %

8. Procédé selon la revendication 7, dans lequel après l'obtention (10) du modèle de structure d'agencement de pixels optimisé, le procédé comprend en outre :

le réglage d'un paramètre graphique et d'un paramètre de position pour chaque première électrode (411, 412 ou 413) dans un panneau d'affichage transmettant la lumière cible, selon un paramètre graphique et un paramètre de position correspondants d'une première électrode correspondante (411, 412 ou 413) dans le modèle de structure d'agencement de pixels optimisé.

9. Procédé selon la revendication 7, dans lequel l'élaboration (10) du modèle de structure d'agencement de pixels initial comprend :

l'acquisition d'une structure d'agencement de pixels d'un panneau d'affichage transmettant la lumière cible et d'un paramètre graphique initial et d'un paramètre de position initial d'une première électrode (411, 412 ou 413) de chaque sous-pixel du panneau d'affichage transmettant la lumière cible ; et

l'élaboration du modèle de structure d'agencement de pixels initial, selon la structure d'agencement de pixels du panneau d'affichage transmettant la lumière cible et le paramètre graphique initial et le paramètre de position initial de la première électrode (411, 412 ou 413) de chaque sous-pixel du panneau d'affichage transmettant la lumière cible.

10. Procédé selon la revendication 7, dans lequel l'ajustement (20) d'au moins un de paramètres graphiques initiaux et de paramètres de position initiaux d'au moins une partie de premières électrodes (411, 412 ou 413) dans le modèle de structure d'agencement de pixels initial pour obtenir le modèle de structure d'agencement de pixels optimisé, un rapport entre l'énergie de point de diffraction d'ordre zéro du modèle de structure d'agencement de pixels optimisé et l'énergie de transmission de lumière du modèle de structure d'agencement de pixels optimisé est supérieur ou égal à 85 % comprend :

la détermination de savoir si un rapport entre l'énergie de point de diffraction d'ordre zéro du modèle de structure d'agencement de pixels initial et l'énergie de transmission de lumière du modèle de structure d'agencement de pixels initial est supérieur ou égal à 85 % ou non dans des conditions de longueurs d'onde d'irradiation, de champs de vision et de distances d'objet différents ;
sous une condition telle que le rapport n'est pas supérieur ou égal à 85 %, l'ajustement en continu d'au moins un des paramètres graphiques initiaux et des paramètres de position initiaux d'au moins une partie des premières électrodes(411, 412 ou 413) dans le modèle de structure d'agencement de pixels initial, jusqu'à ce que le modèle de structure d'agencement de pixels optimisé soit obtenu, permettant au rapport entre l'énergie de point de diffraction d'ordre zéro du modèle de structure d'agencement de pixels optimisé et l'énergie de transmission de lumière du modèle de structure d'agencement de pixels optimisé d'être supérieur ou égal à 85 % dans les conditions de longueurs d'onde d'irradiation, de champs de vision et de distances d'objet différents.

Constructing an initial pixel arrangement structure model, a first electrode of each sub-pixel in the initial pixel arrangement structure model having an initial graphic parameter and an initial position parameter ⟋~10

Adjusting at least one of initial graphic parameters and initial position parameters of at least a part of first electrodes in the initial pixel arrangement structure model to obtain an optimized pixel arrangement structure model, a ratio of zero-order diffraction spot energy of the optimized pixel arrangement structure model to light transmission energy of the optimized pixel arrangement structure model being greater than or equal to 85% ⟋~20

**Fig. 1**

Model construction module
201

Parameter adjustment module
202

**Fig. 2**

Q

40
30

100

**Fig. 3**

**Fig. 4**

**Fig. 5**

**Fig. 6**

**Fig. 7**

AA2     AA1          NA

200

**Fig. 8**

**EP 4 123 714 B1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 110017969 A

- CN 110782807 A